Europäisches Patentamt

European Patent Office

Office européen des brevets

(11) Publication number: **0 199 031**
**A2**

## (12) EUROPEAN PATENT APPLICATION

(21) Application number: 86102869.4

(22) Date of filing: 05.03.86

(51) Int. Cl.⁴: **H 03 J 5/24**
**H 04 B 1/18**

(30) Priority: 08.03.85 IT 2104985 U

(43) Date of publication of application:
29.10.86 Bulletin 86/44

(84) Designated Contracting States:
AT BE CH DE FR GB LI LU NL SE

(71) Applicant: Motta, Tino Giuseppe
Via A. Grandi 143/A
I-20043 Arcore (Milano)(IT)

(71) Applicant: Motta, Natale
Via A. Grandi 143/A
I-20043 Arcore (Milano)(IT)

(71) Applicant: Zappa, Emilia
Via A. Grandi 143/A
I-20043 Arcore (Milano)(IT)

(72) Inventor: Motta, Tino Giuseppe
Via A. Grandi 143/A
I-20043 Arcore (Milano)(IT)

(72) Inventor: Motta, Natale
Via A. Grandi 143/A
I-20043 Arcore (Milano)(IT)

(72) Inventor: Zappa, Emilia
Via A. Grandi 143/A
I-20043 Arcore (Milano)(IT)

(74) Representative: Lecce, Giovanni
Dott. Giovanni Lecce & C. S.r.l. Via G. Negri 10
I-20123 Milano(IT)

(54) Television set operating in the VHF and UHF frequency bands.

㊼ Television set, operating in the VHF or UHF frequency band, inclusive of one or more radiofrequency inputs (B1) (B2) (B3) (X) (Y) operating in total or partial mode on all the bands that can be received by the set, at least one RF selector-commutator (B) or (BB) the entry connected to the relative RF inputs and to the output of tuner (C), and at least a decoding, storage and actuator circuit (D) the operates on said selector-commutator (B) or (BB), following pulses or commands received from circuits (D).

FIG.1

EP 0 199 031 A2

- 1 -

# TELEVISION SET, OPERATING IN THE VHF AND UHF FREQUENCY BANDS.

The invention being considered refers to a televion set operating in the VHF and UHF frequency bands. More specifically, present invention refers to a television set operating in the VHF and UHF frequency bands equipped with two or more radio frequency automatically switchable inputs operating either totally or partially on identical frequency bands or on all the frequency bands that can be received by said sets.

The expression television set, as employed in the present description and in the claims, includes all those devices that are related to television reception and are able to receive programs broadcast on VHF and UHF frequencies, such as radios, television sets, TY projectors, video-reproducing recorders, video-reproducing units and the like.

A problem particularly felt in the field of radio and television receivers has developed, caused by the great increase registered in the number of broadcasting stations. It is a well known fact that normal units at the present state of the art, do not permit as yet a comfortable and true reception of the many programs or frequencies that can be received potentially and whose signals, for economical or technical reasons, very often are not delivered to the normal television sets, whether they be in individual, collective or centralized installations.

Since the normal receiving sets described above are equipped with a sole RF input capable of operating on a certain definite band of frequencies, as for example distinct VHF and UHF bands, or as it is more common at the

- 2 -

present time, with a sole VHF/UHF, it turns out that it is not possible to link the receiving set with more groups of adjacent RF signals, broadcast on the same band and received from several RF sources, identical of different, without running into unpleasant phenomena, as described further below.

Yet, there are some receivers that are equipped with their own built in antennas and with the capacity of being able to select theoretically in a normal way, signals received from said antennas  or signals received from an RF input, through the manual activation of a lever leading to an electric switch tied into the two radiofrequency inputs, or by inserting in the set a connector which will in turn operate an electric contact.

Such a system, besides requiring that the user operate manually the above mentioned electric switch, which at times might be inconveniently located, does not meet its predetermined scope, which is the selection of the desired input. As it is known, this occurs specially in the UHF band, where the opening of an electrical contact does not correspond to the actual opening of a radiofrequency circuit; due to this effect, signals received from various sources overlap and create a number of problems. For this reason, this system has not been used for some time.

An expedient generally adopted by the user in trying to obtain a good reception for more programs, in addition to those normally delivered by the centralized distribution system, and without having to get up from his seat to effect manual switching operations while listening or viewing a program, consists in linking together the installation already existing in his apartment, to one or more supplementary individual internal or external antennas, specific for receiving the desired programs, by means of couplers or mixers permanently tied in to the system in question.

In this way, all the various input signals are mixed and all are contemporaneously inserted in the only RF input suited for the reception of a determined band of frequencies in normal receiving units.

This device allows only for the partial solution of the reception problem due to problems consequent upon the fact that at the input of the television set may arrive contemporaneously signals that technically are mutually incompatible, and even with the same broadcasting frequency.

These, and other problems, can create reception interferences in the unit and, in some cases, they can create interferences also for the signals received by units of other users connected to the same centralized system.

A second known device consists in supplying the receiver's RF input, alternately and in function of the preselected program, with RF signals received either from the centralized system or from the internal or external antennas that every user has installed in appropriate locations. Terminals are used for this purpose, each one connected to its own RF source, plugged in or connected manually in turn to the receiver's RF input, depending on the chosen program.

Such a solution, even if technically functional, creates hardships for the users: every time they desire to receive a certain selected program, they must get up from their seats while listening to or viewing a program, and manually connect and disconnect said terminals; very often, since the receiver's RF input is generally housed in the back of the set, they are also often to be found in rather inconvenient positions.

Another known device is a manually operated RF switch, user installed on the outer part of the televion set.

Such electronic, electrical or mechanical switches may turn out to be inserted in a portable antenna of known design and available to users. With such a device, correctly connected to a television unit and to the various RF sources, the user is given the possibility of selecting manually the RF source or the supplementary antenna whose signal has to be picked up for transmission to the television unit. This solution, as the ones mentioned above, has the inconvenience of causing the user to leave his observation or listening post in order to carry out the change over by operating manually on the switching device, with ensuing discomfort if·the device were to be operated fairly often and not housed in a readily accessible location.

It is also known that in some cases the poor or insufficient separation between the various RF inputs of the above mentioned switching devices utilized for that purpose, and/or the insufficient dampening of signals originating from the remaining RF inputs not selected by the realization of a satisfactory selection or changeover, creating thus problems similar to the ones described above.

Scope of the present invention is to enable the construction of the televion unit that overcomes the above mentioned, as well as other disadvantages.

More specifically, scope of the present invention is to consent the construction of a television unit, as defined above, operating in the VHF and UHF frequency bands, that allows the automatic or semi-automatic selection of RF signals coming in from multiple sources, all equal or different with each other, such as: centralized systems, connections to

- 5 -

external antennas or built-in antennas in the receiver unit itself, videogames and various units operating on frequency bands that can be received by the television units in question.

Another scope of present invention is to consent the construction of a television set, as defined above, and operating in the VHF and UHF frequency bands which permits the change over or adequate selection of the various RF inputs available in such a way that RF signals received from RF sources temporarily not selected are blocked or greatly weakened, avoiding also the cross-over or leakage of high level RF signals, coming from the selected input and directed toward the remaining RF inlets temporarily not selected and viceversa, in such a way as to avoid reception interferences to the unit itself and to the other units linked to the same signal destribution system.

An additional scope of this invention is to assure that in the sections of the units relative to video recording and video reproducing, a television receiving set be made available as defined above and operating in the VHF and UHF frequency bands which allows to block or greatly weaken either automatically or semi-automatically all the RF signals present on all the RF inputs with which the unit is equipped, when the reproduction function is operational and in such manner that the RF signals generated by the unit itself are allowed to reach the television screen without noise or interferences.

A yet additional scope is to consent that a television set as defined above, supplied with its own generic built-in antenna, permanently connected inside said unit, or optionally to one of the existing RF inputs external to the unit itself, be given the capacity for automatically selecting the RF signal source without having to frequently and manually connect and disconnect the connector or plug leading to said built-in antenna and avoiding interferences due to cross-over or leakage of RF signals between the various RF inputs.

It has now been discovered by the petitioner that all these and more scopes can be secured by a television unit incorporating:

- at least two similar RF radio frequency inputs operating totally or partially on identical bands or on all the frequency bands received by the unit itself

- at least one switching circuit, known more precisely as RF commutator, preferably electronic, and having several RF inputs leading to the above mentioned RF inputs. Its single RF sections, operating as detailed above for the relative RF inputs, allow to select in turn one of the RF inputs to the television unit and to amplify or to weaken and transmit to the input or inputs of a normal tuner circuit called tuner. Of known design, the same RF signals received from the chosen RF input, at the same time blocking or greatly weakening the RF signals received from the non-selected or temporarily non-utilized RF inputs,

- one decoding and pulse or control actuator circuit which automatically controls the operation of the RF commutator circuit.

The control of the RF commutator circuit actuator con originate from the reception of specific impulses or orders that the user sends by means of the receiver unit remote control to the respective circuits or from the

- 7 -

energizing of one or more readily accessible push buttons mounted on the receiver unit itself. A second version can be made, integrable to the prior one or used by itself, where the automatic control can be made through storage circuits that control the RF commutator circuit when the user, by means of the telecontrol or the corresponding push buttons mounted on the receiver unit, recalls the various channels already memorized. In this last case in particular, the decoding and pulse or control actuator circuit includes also a self-contained memory system for storing the selection of the various RF inputs, as a function of the channel requested by the user and previously stored in the known memory circuits used for storing user's preferred programs.

Such memory circuits used for program storage are known and easily integrated with the autonomous storage system used for memorizing the selection of the various RF commutator RF inputs. The unit's storage and automation potential are thus increased.

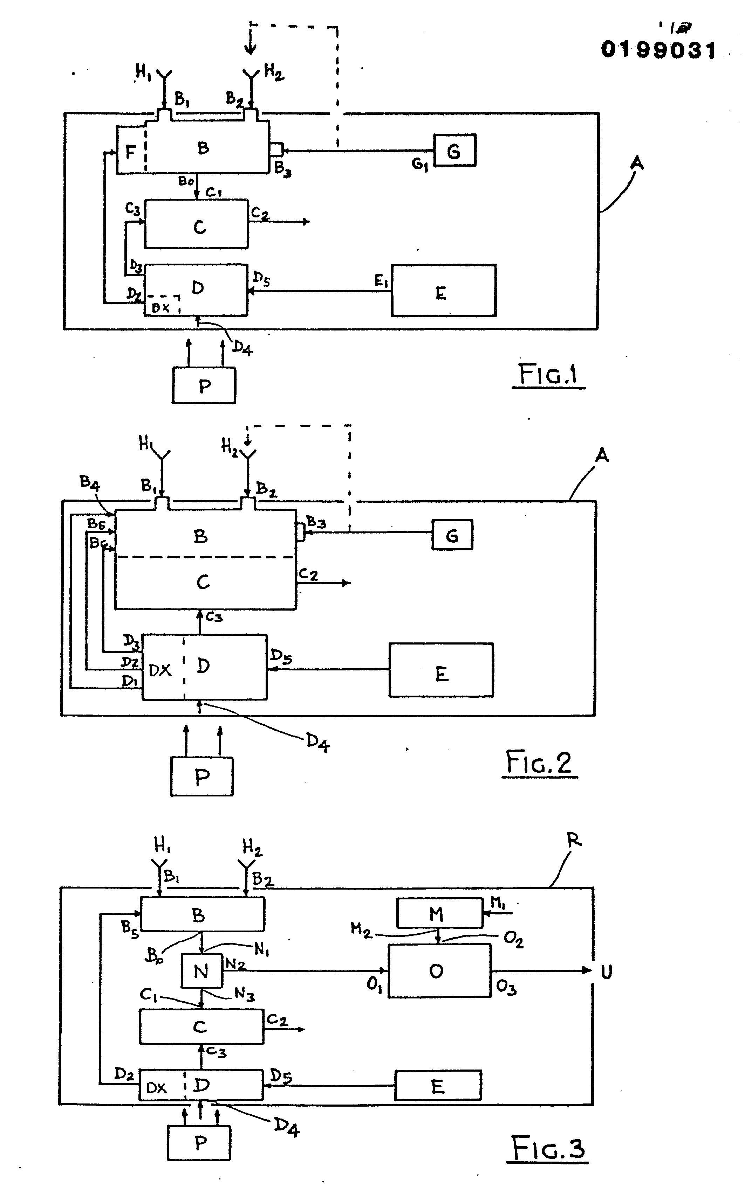

The television unit subject of this invention may be better understood from the following detailed description, and by referring to figures 1 to 5 that represent the block diagrams of some of the possible realizations.

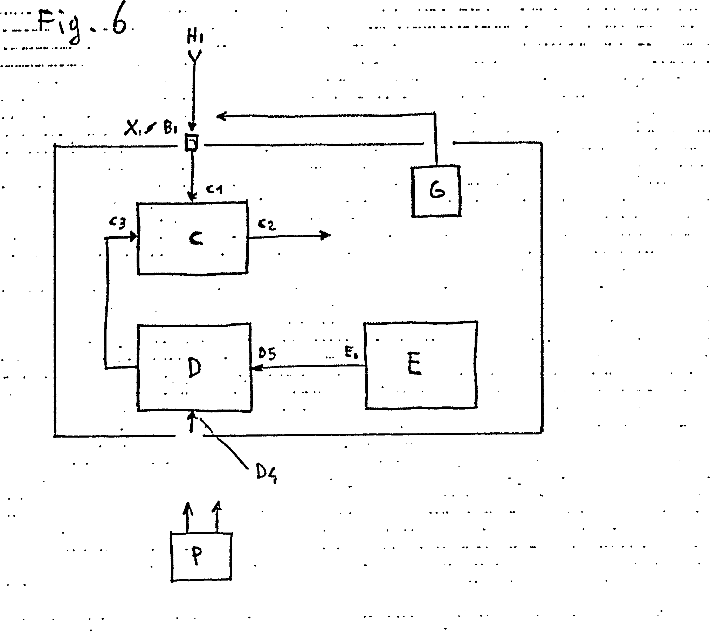

Figure 6 shows a known and existing generic television unit and is given only as a reference. In the diagram shown in Fig. 1, are detailed as:

(A): a television receiving unit, as for example a television or receiving radio set;

(B): an RF selector-commutator, realized preferably with electronic circuitry, which selects the radio frequency inputs (B1),(B2),(B3) and in turn transmits to the outlet (B0) the various RF signals received;

(C): a known electronic tuner where the RF input/inputs (C1) is/are connected to the outlet of the selector-commutator (B0), and the outlet (C2) of the tuner (C), from where the signals it has processed come out to be directed to the other known circuits, not shown and having known functions:

(D): a system for storage, decoding and for carrying out the pulses transmitted by a telecontrol (P) and received from input (D4); comprising a first section of normal known storage, decoding and actuator circuits and generally tied-in and utilized to control the tuner (C), connected to or integral with a second section of circuits (DX) similar to the ones just mentioned and reserved for the automatic operation of the circuit or circuits of one or more of the RF selector-commutators.

(D3): control output to tuner (C) for circuit operation, originating in the first and known section of the circuits contained in (D) and reserved for carrying out the various control operations in tuner (C).

(D2): output of the impulses or voltages originating in the second circuit section (DX) contained in (D) and reserved for control of the selector-commutator (B) through block (F).

(E): a power supply for feeding the voltage or voltages for operating the receiving unit active components.

(F): a control system coupled to selector-commutator (B), which responding to signals and/or voltages received from section (DX), through output (D2), allows selector (B) to operate. When employing an eletronic selector-commutator (B), block (F) may be left out, and

- 9 -

in this event block (DX) controls directly the selector-commutator (B) with the same output (D2).

(G): an antenna, internal or built-in in the receiver, permanently connected to input (B3) of selector (B) or so prepared that the user, if he so desires, can connect it to one of the inputs (B1) or (B2) by plugging the lead derived from said antenna (G) and available outside the set itself into one of the RF inputs provided on selector (B) obtaining thus for the same its automatic commutation.

(H1)&(H2):two radio frequency sources, equal or different, generated, for example, from receiving, antennas, RF signals distributing systems, television cameras, videogames or other RF equipment.

The television set, object of this invention, is equipped with two or more radio frequency (RF) inputs operating totally or partially on identical bands or on all the frequency bands that can be received by the set; the difference being that in the known television sets, even though equipped with two or more inputs, each input is operational for a different or distinctive freqguency band, as for example, one input being for VHF and the other for UHF or one for AM and the other for FM.

Power supply (E), through normal line voltage and output (E1), supplies the D.C. voltage or voltages required for receiver and/or receiving system operation.

When sending pulses or comands with a remote control unit (P) for changing channels through input (D4), block (D) containing a known system for storage, that the user has previously memorized, and for decoding and actuation of the signals or controls received, energizes that section of circuit (DX) which incorporates a second section of memory and actuation circuits. This one, due to the coupling "reception channel ——➤ RF input" to be selected made in advance by the user and stored by him in the set, sends pulses or voltages to output (D2) energizing block (F).

The control system (F), reacting to said pulses or voltages, operates selector-commutator (B) which transmits to the RF input or inputs (C1) of tuner (C) the selected group of signals or radio frequencies received from one of the various RF inputs (B1), (B2),(B3) linked with the respective radio frequency sources (H1),(H2),(H3). Simultaneously to the control or controls sent to block (F) through output (D2), tuner (C), reacting to the control or controls sent to its input (C3) through output (D3) of block (D), tunes in a channel or preselected program in known manner sending it to output (C2), processing its frequency and/or strength and with characteristics dependent on tuner performance.

From output (C2) the program or channel being tuned in undergo further processing, as occurring in traditional television receiving sets. This occurs in the event of utilization of storage circuits housed in the second section of circuits (DX) of block (D) switching automatically the various inputs (B1), (B2),(B3) depending on the program or channel memorized in the first section of (D).

In case one were to desire that switching of inputs (B1),(B2),(B3) of selector-commutator (B) should occur indipendently from the channel or program stored in the first part of the storage circuits housed in (D), it is sufficient to preset the second section (DX) of block (D) in such a manner it can transmit pulses, controls or voltages to output (D2) only when it receives a special signal incoming from telecontrol (P) through the decoding circuits housed in (D) or from special push buttons, set on the receiving unit itself, and not every time the various programs are selected through telecontrol (P) or normal keys or push buttons.

In short, telecontrol (P) and/or the television receiving set must be equipped with one or more switch buttons for said inputs, dependent on the traditional program selection push buttons, and the second section (DX) of the circuits housed in (D) shall not contain storage circuits but only decoding circuits and circuits for carrying out signals transmitted by telecontrol (P) or from keys or push buttons set on the receiver itself.

Figure 2 illustrates a variant of figure 1, where the RF selector-commutator (B) to which the various radio frequency sources (H1),(H2),(G) can be connected is constructed inside the tuner (C) and said selector (B) is controlled directly from the storage decoding and actuator system (D) through its various outputs (D1), (D2), (D3), leading, as in Figure 1, to the second section (DX) of the circuits housed in (D). Said output or outputs send control voltage and operational voltage or voltages individuallyin single manner and/or simultaneously to the respective control inputs (B4), (B5), (B6) of the RF selector-commutator (B).

The operation of the television set subject of present invention, can be better understood from the following description.

While referring to Figure 6, where the essential elements of a known television receiver are illustrated, and to the other figures, following right here below the invention's construction and innovative principles are more clearly defined.

- 12 -

The television set shown in Figure 6 includes known component elements, as circuits for RF reception, for RF tuning, for preselected channel storage, for decoding and actuation of signals or controls sent by the telecontrol unit or from power feed.

In particular, the television set shown in Figure 6 includes:

-    one RF input (B1) or (X), which is wired to or is integral with a tuner (C) and manually connectable in turn to the various RF sources, such as a built-in antenna (G), a reception system (H1) or other;

-    one tuner (C) which tunes the channel selected and transmits the processed signal to output (C2);

-    one section housed in block (D) and containing storage, decoding and actuator circuits, each wired from its own output to the inputs of tuner (C) and collectively shown as (C3);

-    one telecontrol unit (P) with relative push buttons mounted on the receiving unit and not shown for bettere ease in understanding

-    one power circuit (E).

The television units, subject of this invention and shown in Figures 1-5, besides the above mentioned components include also:

-    at least a second RF input (B2) or (Y) located in the set and accessible from the outside, characterized by the fact that it is operating either in a total or partial way on frequency bands identical with those processed by the pre-existing RF input, or it is operating on all the frequency bands that can be received by the television set;

-    possibly another RF input (B3), operating as the ones mentioned above, but not accessible from the outside of the set.

- 13 -

- at least an RF selector-commutator (B) and/or (BB). Its single RF sections, corresponding to the number of commutable RF inputs, are also operating in a total or partial way on identical frequency bands or on all the frequency bands that can be received by the set to which said selector-commutator (B) and/or (BB) is applied; these RF selector-commutators are preferably electronic, but other types can also be employed.

- Possibly one or more connector or adapter circuits (N) as better defined further below;

- one or more new electronic circuits sections (DX) each inclusive of: a controls actuator system for controls received from push buttons located on telecontrol (P), and if required its own storage circuit.

This one or these new circuit sections are connected to a pre-existent decoding actuator and storage system (D), now strenghtened.

More precisely, every control output from these new sections, contained in blocks (DX) of figures 1-5, is wired to control inputs (B2), (B5), (B6), BB5) or to the respective slave circuit (F) of a selector-commutator (B) and/or (BB), and every input of the same sections is interfaced with the first section of the storage, decoding and actuator circuits already installed in normal television sets.

The number of these circuits depends then on the number of RF selector-commutators (B) or (BB) installed. Through the application of these devices, the television set is able to select automatically the various RF inputs or the various RF sources to which it is connected, and, more precisely, it is able to effect said automatic operation in one or more of the following ways, selected on ground of the specific requirements of the manufactured unit or else employing indifferenty all the described operating modes.

The first operating mode for the unit equipped as indicated, is described synthetically in the first part of Figure 1 analysis and is as follows:

Sending a command to the set's shown circuits (D) from the telecontrol unit (P) through input (D4) or from switches or pushbuttons installed on the set and not shown, so that the television set is made to operate a selection for a specific desired channel or program that has been stored beforehand by the user in the memory storage -circuits included in (D), the decoding, storage and actuator circuits transmit commands from their outputs to the control inputs of tuner (C), shown globally as (C3), so that the tuner (C) can select in a known mode the required channel or program and transmit it processed to the remaining receiver circuit through output (C2).

At the same time and automatically the set (A) or (R) conducts an exchange of information between the storage circuits housed in (D) and the storage circuits housed in (DX) where the user has beforehand stored also the various couples "channel stored in (D) —>RF input (B1), (B2 (B3) or (X), (Y)" to be selected and by means of actuator circuits, always housed in (DX), and controlling the operation of the RF commutator (B) and/or (BB).

By means of the same RF selector-commutator, the set selects automatically from which of the RF inputs (B1), (B2), (B3) or (X) (Y) the signal has to be picked-up.

A second operating mode for a unit equipped as indicated is described synthetically in the second part of Figure 1 analysis, and is as follows:

Sending a command to the set's known circuits (D) from the telecontrol unit (P) or from switches or pushbuttons installed on the set so that set (A) or (R) can be made to tune-in to the user's requested program or channel, in any known mode utilizing known circuits (C) and (D), the set tunes in the desired channel, indipendently from which RF input (B1), (B2), (B3) or (X) (Y), the RF selector-commutator (B) or (BB) turns out to be switched on.

After this first operation, user evaluates if the channel tuned in by the set from a first RF input is received correctly. If this were not the case, user operating on a specific pushbutton or switch located in the telecontrol unit (P) or on the set itself (A) or (R) transmits through known circuits, a command to the decoding circuits housed in (D). The circuits in (D), enhanced as compared to known circuits (D), carry out decoding of the control signal received and send it to the actuator circuits (DX). These, through their output connected to one of the control inputs (B4), (B5), (B6) or (BB5) of the RF selector-commutator (B) or (BB) carry out the command received by having the selector-commutator (B) or (BB) tune in automatically to a second RF input.

This last operation is repeated for tuning in to a third input, if necessary. Essentially, the user must send a command to the set's circuits either by means of telecontrol (P) or the set's pushbuttons, everytime he desires to carry out automatic switching of inputs (B1), (B2), (B3) or (X) (Y), in addition to the normal commands required for carrying out the selection and tuning of the preselected channel; such commands are indipendent and separate from other commands assigned for carrying out the set's normal functions.

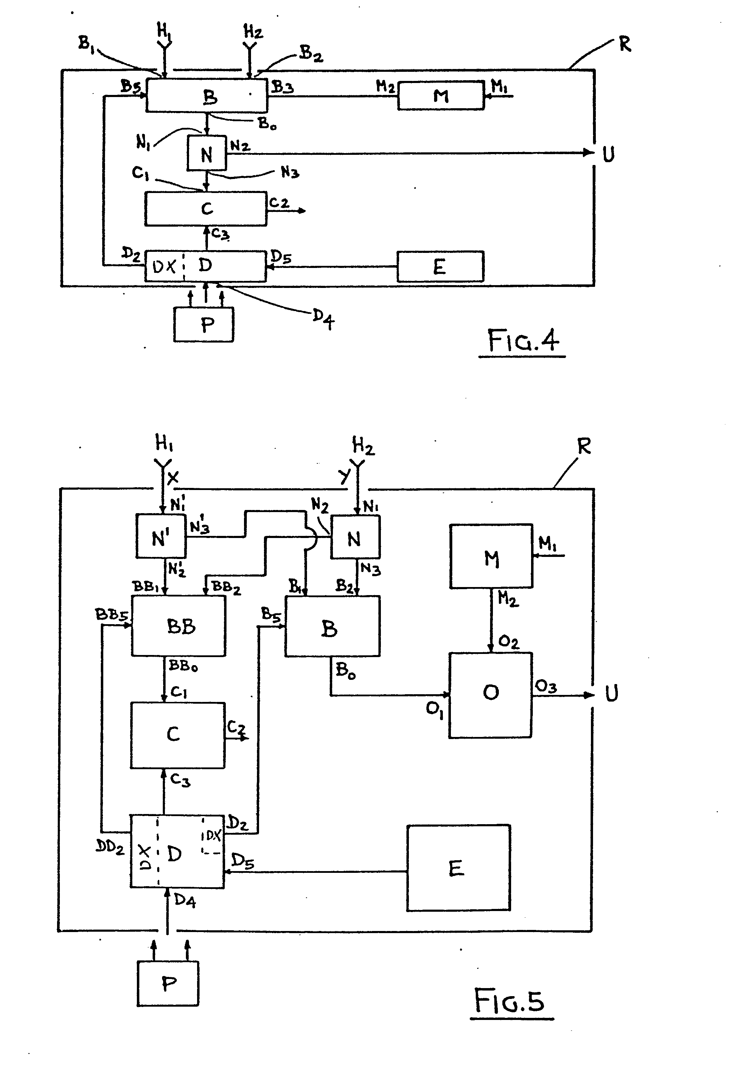

Figures 3, 4 and 5 illustrate with block schemes other possible elaborations of the RF reception and modulation sections, of a video recorder, of a video reproduction unit and of a tuner: tuner to be coupled to a portable video recorder and reproduction unit.

As in the foregoing diagrams, in the figures have been illustrated only the relevant elements, that are related to the device new concepts and omitted all the other known elements.

Figure 3 refers to the receiving section of a video-recorder (R) or tuner/tuner, to be coupled with a portable video recorder, equipped with two radiofrequency inputs (B1) and (B2), both operating on all the frequency bands that are receivable by the video-recorder. These inputs are alternately switchable by the selector-commutator (B). Its intervention is obtained by means of pulses or voltages sent from one section (DX) controlled by block (D), through exit (D2), to said selector-commutator (B) control input (B5), as already described when referring to Figure 1 and 2 diagrams and the general operating principles.

The only difference is to be found in blocks (N), (O) and (M), each representing known circuits having the following functions:

- Block (N) is made up by circuits that match and transmit to all its outputs (N2) and (N3) all the radiofrequency signals received at input (N1) of said block (N);

- Block (O), generally installed, has the function of passing through the RF signal received from output (N2) of block (N) and are directed to the RF output (U) of set (R) and/or to transmit an RF signal generated by modulator (M) from its output (M2) to the RF output (U) of set (R), when in the reproduction mode;

- Block (M) represents the videorecorder RF modulator, and generally installed, its known function is to modulate an RF signal, with a definite frequency, through compound video signals arriving at input (MI) from the remaining circuits leading from the videorecorder or video reproduction units sensing mechanisms, when the reproduction functions are being activated.

As in the foregoing diagrams, block (C) represents a tuner normally installed in the set and which, when operating, in the recording mode, is used for tuning a certain program or channel to be recorded, from between all those present at RF input (CI), and transmit it from output C2 on to the remaining recording circuits.

Figure 4 illustrates a variant to the block diagram shown in Fig. 3. More specifically, the RF signal generated and modulated by modulator (M) at the moment the reproduction mode functions become operational is brought to output (U) of set (R) through block (B1) and/or (B2).

The diagram shown in Fig. 5 represents a variant to the RF receiving and modulating section of a videorecorder with multiple indipendent and commutable RF inputs, as in the above diagrams.

The example refers to a simple solution with 2 inputs, but not excluding the possibility of producing units with a greater number of inputs.

By adopting the constructive solution shown in the above mentioned diagram, it is possible to select from which videorecorder RF input, (X) or (Y) the program to be recorded has to be picked up and, at the same time, select from which RF input, (X) or (Y) can be picked up the various signals to be transmitted through output (U) and indipendently from the television receiving set.

This mode of operation allows the recording of a specific program being received through one input (X) or (Y) and to select indipendently and contemporaneously which programs are to be sent to the television set, whether they are being received from input (X) or (Y).

The circuits are modified as indicated, by the introduction of two RF selector-commutators (B) and (BB), of a type similar or not to those employed in precedent solutions, two blocks (N), two sections (DX) and one unit (D) for storage, decoding and actuation of various functions and pulses transmitted by telecontrol (P) or from other pushbuttons set on unit (R). Block (D) shows two circuits (DX) from which are derived distinct outputs generically shown as (D2) and (DD2), which can operate contemporaneously and independently their respective selector-commutators (B) and (BB).

If one desires to further increase the number of RF inputs, it is sufficient that for each additional RF input the following be increased by one unit: block (N), selector (B) and circuits (DX) leading to the outputs (D2) or (DD2) of block (D).

The difference between this last solution and the ones examined before is to be found in the fact that it is possible to control separately and contemporaneously the selector-commutators (B) and (BB), the respective outputs (D2) and (DD2) from unit (D) and, in particular, possible to it is select automatically inputs (BB1) and (BB2) of selector-commutator (BB), leading to the recording circuits of the videorecorder and, depending on the program to be recorded and indipendently from inputs (B1) or (B2) of selector-commutator (B), leading to the output circuits dedicated to the television receiver.

Videorecorders and video reproducing units equipped with the above mentioned devices as shown schematically in Figures 3, 4 and 5, besides producing all the advantages to be derived from the availability of two or more RF inputs (B1), (B2), .... (Bn), switchable as in the television receivers shown in Fig. 1 and 2, have the advantage of being able to block or to reduce drastically the passage toward output (U) of set (R), of all the RF signals received on inputs (B1), (B2) .....(Bn), when in the reproducing mode, and sending to output (U) the RF signal generated and modulated by block (M), avoiding inter-modulation interferences, streaking, cross modulations and the like.

The exclusion of the RF inputs tied in to the various antennas or signal sources (M1) and (M2) can be obtained by controlling selector-commutator (B) and/or (BB) utilizing one of the following systems, either by itself or jointly:

a) automatically through the storage and actuator circuits included in groups (D) and (DX), when selecting for operation in the reproducing mode;

b) by means of pulses sent from telecontrol (P) to the input (D4) of block (D);

c) by means of a specific pushbutton installed on the video recorder or video reproducing unit.

This turns out to be particularly useful in all the cases where video recorders and video reproducing units are forced to operate with an elevated number of incoming programs or where one of the channels or programs turns out to be adjacent, on the same frequence or such as to interface with output RF signal, directed to the television set.

With the above described arrangements one can avoid the superimposition or overlap of programs or channels to the RF signal generated by the video recorder or video reproducing unit while in the reproducing mode.

The above mentioned intermodulation interferences, streaking and cross modulation can thus be kept from appearing on the images transmitted to the television set.

Selector-commutators (B) and/or (BB) can be of any known type, but preferentially electronic models are utilized and more specifically, the selector-commutators shown and described in the italian Patent Application no. 19762 A/85 deposited on March 5, 1985 are particularly suited for this scope.

CLAIMS

1.    Television set operating in the VHF and UHF frequency bands, comprehensive of an RF input (B1) or (X), a tuner (C) and circuits (D) for decoding, storage and actuation of normal equipment functions, characterized by the existence of other additional RF inputs (B2), (B3), (Y) operating totally or partially exclusively on frequency bands chosen from those at an RF input and those receivable by the television set; at least one RF selector-commutator (B) or (BB), having all its RF inputs connected to the respective RF inputs (B1), (B2), (B3) or (X) (Y) and with the RF output (B0) to the RF input circuit of tuner (C); and at least a section of actuation and/or storae circuits (DX), which operate their respective selector-commutator (B) or (BB) following impulses or commands received from circuits in (D).

2.    Television set, as described in Claim 1, distinguished by the fact that all the RF inputs (B), (B2), (B3) and (X) or (Y) are connected to at least one selector-commutator (B) or (BB) controlled by an actuator circuit (DX) with signals received from (D), where the individual RF sections individually connected to their relative RF inputs (B1), (B2), (B3) or (X) (Y) are operating exclusively either totally or partially with identical frequency bands or with all the frequency bands receivable by the set itself.

3.    Television set, as described in claims 1 or 2, distinguished by the fact that every selector-commutator (B) or (BB) is electronically controlled by voltages or electronic pulses sent to one or more of its inputs (B4) (B5) (B6) (BB5) from the relative outputs to the storage and actuator circuits sections (DX), with the known decoding, storage, actuator circuits (D) of the known normal functions, enhanced with the aim of obtaining such a scope.

4. Television set, as described in one of claims 1 to 3, where the impulse decoding and actuator system (D) and (DX) acts on the selector-commutators (B) and/or (BB) as consequence of pulses or voltages received directly from storage circuits housed in blocks (D) and (DX), from receiving set's telecontrol units, or from circuits leading to control devices of the recording functions of video recorders or video reproducing units.

5. An apparatus, as described in one of the above claims, where at least a selector-commutator (B) and/or (BB) in incorporated in the the housing of tuner (C).

6. An apparatus, as described in one of the above claims, where the RF inputs (B1) (B2) (B3) or (X) (Y) are realized on the same housing of the RF selector-commutator (B) and (BB).

7. Television set as described in one of the above claims, distinguished by the fact that it is comprehensive of at least one electronic circuit section (DX), each including one circuit for the actuation of commutation commands from the RF selector-commutator (B) or (BB) received from separate pushbuttons or buttons housed in the set itself, and/or from circuits leading to their relative pushbuttons housed in the telecontrol unit (P), or from circuits coupled to reproduction functions actuating devices, or from one of its own additional storage circuits interfaced of with the pre-existent and enhanced decoding, storage and actuating circuit (D).

8. Television set, as described in one of the above claims, distinguished by the fact that the radio frequency inputs (B1) (B2) (B3) or (X) (Y) are coupled to are electronically controlled commutation system (B) (BB) (DX) and (D).

9.   Television set, as described in anyone of the above claims, comprehensive of an antenna (G) that can be connected externally to the RF inputs (B1) or (B2) or that can be connected internally in a permanent manner to the set's RF input (B3).

10.   Television set, as described in anyone of the above claims, distinguished by the fact that the individual radio frequency inputs (B1) (B2) (B3) or (X) (Y) operating exclusively in total or partial mode on the same frequency bands or each on all the frequency bands receivable by the set and can be automatically and electronically selected, through the selector-commutator (B) (BB) and related circuits (DX), either by the set or by the user.

0199031

FIG.1

FIG.2

FIG.3

_Fig.4_

_Fig.5_

Fig. 6

0199031